Europäisches Patentamt

European Patent Office

Office européen des brevets

(11) Publication number: **0 451 377 A1**

## EUROPEAN PATENT APPLICATION

(21) Application number: 90303815.6

(22) Date of filing: 09.04.90

(51) Int. Cl.5: **H01L 29/90**

(43) Date of publication of application:
**16.10.91 Bulletin 91/42**

(84) Designated Contracting States:
**DE FR GB**

(71) Applicant: **MATSUSHITA ELECTRIC INDUSTRIAL CO., LTD.**
**1006, Oaza Kadoma**
**Kadoma-shi, Osaka-fu, 571(JP)**

(72) Inventor: **Kotera, Koichi**
**27-10-305 Sakaemachi**
**Kawanishi-shi(JP)**
Inventor: **Tsuda, Yoshiyuki**
**2-1-902 Kasuga 4-chome**
**Suita-shi(JP)**
Inventor: **Mukai, Yuji**
**20-20-105 Kaminoguchicho**
**Kadoma-shi(JP)**
Inventor: **Yasui, Hideaki**
**30-23, Miyukihigashimachi**
**Neyagawa-shi(JP)**

(74) Representative: **Atkinson, Ralph et al**
**Fitzpatricks Europe House World Trade Centre**
**London E1 9AA(GB)**

(54) **Non-linear resistance element.**

(57) Disclosed is a non-linear resistance element comprising a PIN type or NIN type semiconductor layer (5, 6, 8; 8a, 6, 8b) formed between two electrode layers (4, 11), and a composite layer (7) inserted in the semiconductor layer, the composite layer containing at least one component capable of providing a chemical equivalent for forming an electrical insulator with a component of the semiconductor layer.

## F I G. I

EP 0 451 377 A1

## BACKGROUND OF THE INVENTION

This invention relates to a non-linear resistance element for use in a display device.

In a display device such as a liquid crystal display device or an electroluminescence display device, a high-density matrix structure using an increased number of scanning lines is required so as to display a picture having high definition. As a means for efficiently driving such a matrix, an active matrix drive system is now drawing public attention in which a switching element is disposed at each of display pixels of the matrix. Switching elements most commonly used in the active matrix drive system include a three-terminal type and a two-terminal type. A thin film transistor (TFT) is representative of the three-terminal type switching element, while a metal-insulator-metal (MIM) diode and a thin film diode are representative of the two-terminal type switching element. The two-terminal type switching element is now noted as being suitable for application to an active matrix type display device having a wide display area, because its structure is simpler than that of the three-terminal type switching element, and it can be manufactured with a higher yield rate. Especially, a ring diode (RD), in which two PIN type semiconductor layers are connected in anti-parallel relation, is a non-linear resistance element having a uniform threshold voltage which is substantially free from fluctuation.

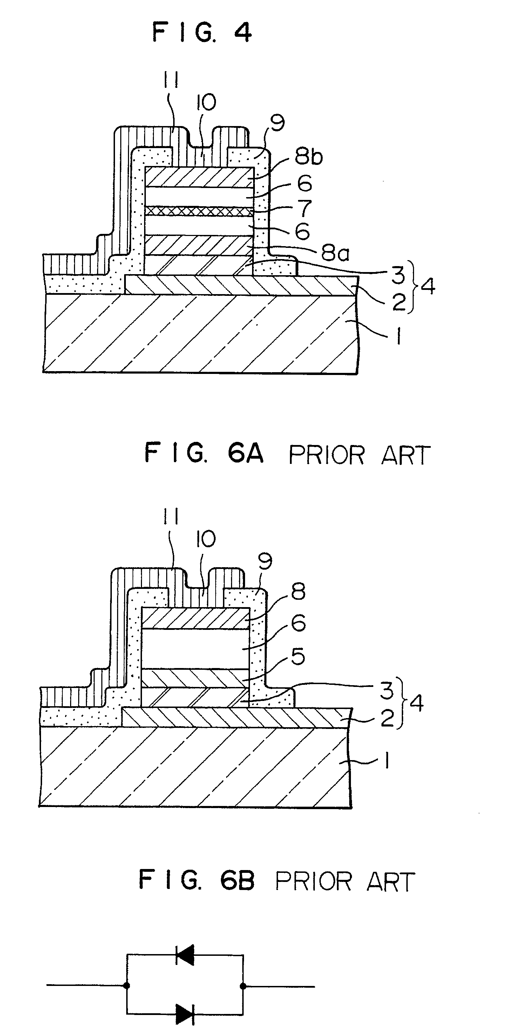

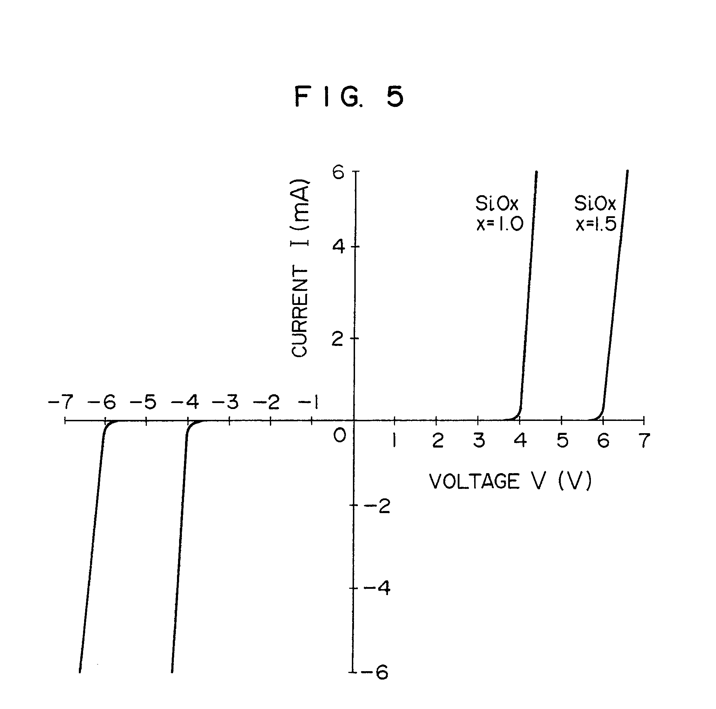

Fig. 6A is a schematic sectional view showing the structure of one form of a diode used hitherto to constitute an RD element used for driving a liquid crystal display device. Referring to Fig. 6A, a transparent electrode layer 2 of an ITO (indium-tin oxide) film is formed on one major surface of a glass substrate 1. This transparent electrode layer 2 forms a pixel electrode of a liquid crystal display device. Then, a buffer layer 3 of chromium (Cr) is laminated on the transparent electrode layer 2 to form a lower electrode layer 4 with the transparent electrode layer 2. A P-type semiconductor layer 5 of P-type amorphous Si:H (referred to hereinafter as a-Si:H), an I-type semiconductor layer 6 of non-doped I-type a-Si:H, and an N-type semiconductor layer 8 of N-type a-Si:H are then laminated sequentially in the above-mentioned order on the lower electrode layer 4. Then, an interlayer insulator layer 9 having a central contact hole 10 is formed on the laminate, and an upper electrode layer 11 of Cr is finally deposited on the laminate to complete the diode element. A diode element having the same structure as this diode element is disposed adjacent to this diode element, and the transparent electrode layers and upper electrode layers of these two diode elements are mutually connected in a reverse-parallel configuration to thereby provide an RD element in which the two diodes are connected in anti-parallel relation as shown in Fig. 6B. The diode elements forming this RD element exhibit equivalent voltage-current (V-I) characteristics in response to application of voltages of positive and negative polarities, so that the RD element can deal with driving of a liquid crystal display device by an a.c. voltage.

However, the most serious disadvantage of this non-linear resistance element is that its threshold voltage level is as low as 0.7 V. Commonly, a threshold voltage having a level more than 1.5 times as high as that of a liquid crystal driving voltage is required. Therefore, when a liquid crystal material operating at a liquid crystal driving voltage of 3 V is employed, a threshold voltage of 4.5 V is required. In order to provide such a threshold voltage, the PIN-type semiconductor layer having the threshold voltage of 0.7 V must be laminated to provide a total of six or seven layers. Thus, the structure of the RD element becomes complex, and its manufacturing process becomes also complex.

## SUMMARY OF THE INVENTION

With a view to solving the prior art problem pointed out above, it is an object of the present invention to provide a non-linear resistance element which is simple in structure and has a high threshold voltage.

In accordance with the present invention, there is provided a non-linear resistance element comprising a semiconductor layer formed between two electrode layers, and a composite layer inserted in the semiconductor layer, the composite layer containing at least one component capable of providing a chemical equivalent for forming an electrical insulator with a component of the semiconductor layer.

The semiconductor layer in the non-linear resistance element is either of a PIN-type formed by laminating a P-type semiconductor layer, an I-type semiconductor layer and an N-type semicondcutor layer in the the above-mentioned order or of an NIN-type formed by laminating an N-type semiconductor layer, an I-type semiconductor layer and an N-type semiconductor layer in the above-mentioned order. The composite layer inserted in the PIn type or NIN type semiconductor layer contains at least one component capable of providing a chemical equivalent for forming an electrical insulator with a component of the semiconductor layer, where, if the semiconductor layer is formed of, for example, silicon semiconductor, the said component of the composite layer is one or a plurality of elements selected from the group consisting of oxygen (O), nitrogen (N) and carbon (C), which is contained in Si. A current, which flows when a voltage is applied across the composite layer in the non-linear resistance element, has a non-linear property, thereby raising the threshold voltage level of the entire resistance element. This threshold voltage increases with an increase in the content of the component of the composite layer contained in the semiconductor and also with an increase in the thickness of the composite layer.

Therefore, the threshold voltage of the non-linear element can be controlled by controlling the content of the component of the composite layer contained in the semiconductor and the thickness of the composite layer, and, besides, a conventionally used low threshold voltage level can be raised up to an appropriate level.

## BRIEF DESCRIPTION OF THE DRAWINGS

Fig. 1 is a schematic sectional view showing the structure of a first preferred embodiment of the non-linear resistance element according to the present invention.

Fig. 2 shows the voltage-current (V-I) characteristic of the non-linear resistance element shown in Fig. 1.

Fig. 3 is a schematic sectional view showing the structure of a second preferred embodiment of the non-linear resistance element according to the present invention.

Fig. 4 is a schematic sectional view showing the structure of a third preferred embodiment of the non-linear resistance element according to the present invention.

Fig. 5 shows the V-I characteristic of the non-linear resistance element shown in Fig. 4.

Fig. 6A is a schematic sectional view showing the structure of a prior art non-linear resistance element.

Fig. 6B shows an RD element formed by connecting two non-linear resistance elements as shown in Fig. 6A.

## DESCRIPTION OF THE PREFERRED EMBODIMENTS

Preferred embodiments of the present invention will now be described in detail with reference to the drawings.

### Embodiment 1

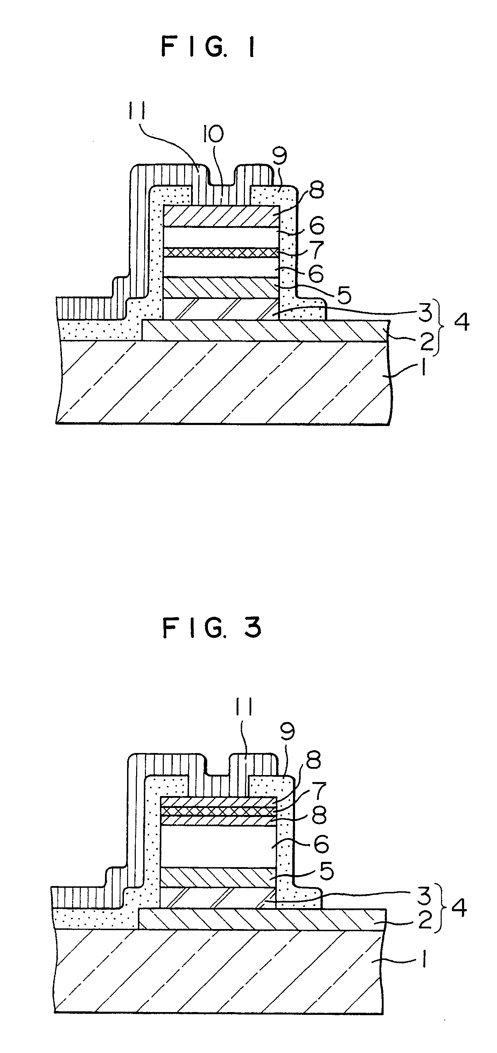

Fig. 1 is a schematic sectional view showing the structure of a first preferred embodiment of the non-linear resistance element according to the present invention, and, in Fig. 1, like reference numerals are used to designate like parts appearing in Fig. 6A.

Referring to Fig. 1, a transparent electrode layer 2 formed of an ITO film having a thickness of 100 nm is formed on a glass substrate 1 by the sputtering method to provide a pixel electrode of a liquid crystal display device. A buffer layer 3 of chromium (Cr) having a thickness of 100 nm is then laminated on the transparent electrode layer 2 to provide a lower electrode layer 4 together with the transparent electrode layer 2. A P-type semiconductor layer 5 of P-type a-Si:H having a thickness of 100 nm is then formed on the lower electrode layer 4 by the plasma CVD method using a raw material gas which has diborane ($B_2H_6$) added to silane ($SiH_4$). Two I-type semiconductor layers 6, in which a composite layer 7 is inserted, are then formed on the P-type semiconductor layer 5. These I-type semiconductor layers 6 are formed of non-doped I-type a-Si:H produced by the plasma CVD method using silane ($SiH_4$) only as a raw material gas. The composite layer 7 is formed of $SiO_x$ ($x > 0$) produced by the plasma CVD method using a raw material gas in which oxygen (O) is added to silane ($SiH_4$). The composite layer 7 is located intermediate between the I-type semiconductor layers 6. The total thickness of the I-type semiconductor layers 6 is 200 nm, and the thickness of the composite layer 7 is 20 nm. An N-type semiconductor layer 8 of N-type a-Si:H having a thickness of 100 nm is then formed on the upper I-type semiconductor layer 6 by the plasma CVD method using a raw material gas in which phosphine ($PH_3$) is added to silane ($SiH_4$), thereby constituting a PIN-type semiconductor layer in which the composite layer 7 is inserted.

An interlayer insulator layer 9 of $SiO_2$ having a thickness of 200 nm and having a central contact hole 10 is then formed on the PIN-type semiconductor layer, and an upper electrode layer 11 of Cr having a thickness of 100 nm is then formed on the interlayer insulator layer 9. A non-linear resistance element having the same structure as this non-linear resistance element is disposed adjacent to this non-linear resistance element, and the transparent electrode layers and upper electrode layers of these two elements are mutually connected in a reverse-parallel configuration to thereby provide an RD element in which the two diodes are connected in anti-parallel relation.

The RD element having such a structure makes it possible to drive a liquid crystal display device with voltages of positive and negative polarities.

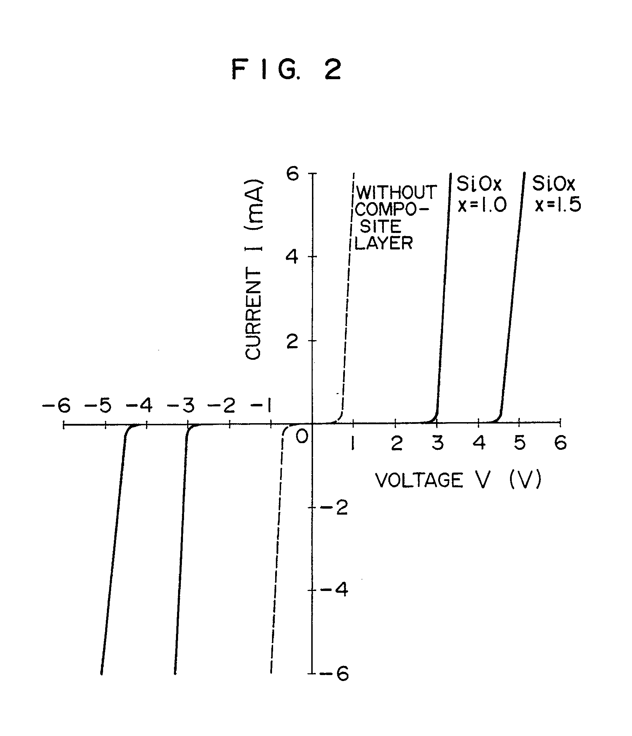

Fig. 2 shows the voltage-current (V-I) characteristic of the RD element formed of the non-linear resistance elements having the structure shown in Fig. 1. This V-I characteristic was observed when the thickness of the composite layer 7 was set at 20 nm and the content of oxygen in the raw material gas supplied to form the composite layer 7 was changed thereby changing the value of x in $SiO_x$. The broken curve in Fig. 2 shows, for the sake of comparison, the voltage-current (V-I) characteristic of such an RD element when the composite layer 7 was not provided. In this case, it will be seen that the threshold voltage level where the resistance value sharply decreases and the current value shaply increases in such an RD element is about 0.7 V. In contrast, in the case of the RD element according to the first embodiment of the present invention which includes the composite layer 7, the threshold voltage level can be raised, and this value can be increased with an increase in the value of x. Also, because of the RD structure, the voltage-current (V-I) characteristic is equivalent for both the voltages of positive and negative polarities.

Thus, according to the first embodiment, the threshold voltage level of the non-linear element can be raised, and its value can be suitably controlled by adjusting the value of oxygen contained in the composite layer 7. The threshold voltage level can also be controlled by changing the thickness of the composite layer 7 while fixing the value of x in the composite layer 7. That is, the threshold voltage level can be raised by increasing the thickness of the composite layer 7, so that the threshold voltage is controllable over a wide range.

Embodiment 2

Fig. 3 is a schematic sectional view showing the structure of a second embodiment of the non-linear resistance element according to the present invention. In Fig. 3, like reference numerals are used to designate like parts appearing in Fig. 1. In this second embodiment, a composite layer 7 is inserted in N-type semiconductor layer 8, and a composite layer 7 comprising Si semiconductor, which contains nitrogen (N), is used. As in the case of the first embodiment, after a transparent electrode layer 2, a buffer layer 3 and a P-type semiconductor layer 5 have been laminated sequentially in the above-mentioned order on a glass substrate 1, an I-type semiconductor layer 6 having a thickness of 200 nm is then formed on the P-type semiconductor layer 5. The two N-type semiconductor layers 8 are then formed on the I-type semiconductor layer 6 so that the composite layer 7 is interposed therebetween. The N-type semiconductor layers 8 are formed by the plasma CVD method using a raw material gas in which phosphine ($pH_3$) is added to silane ($SiH_4$), while the composite layer 7 is also formed by the plasma CVD method using a raw material gas in which nitrogen (N) is added to silane ($SiH_4$). In this case, phosphine ($pH_3$) is not added to the raw material gas used to form the composite layer 7. However, even if phosphine is added to the raw material gas, the result is merely to slightly change the threshold voltage, but no problem is posed in elevating the threshold voltage level. As to the film thickness, the N-type semiconductor layers 8 have a total thickness of 100 nm, and the composite layer 7 has a thickness of 20 nm. As was the case with the first embodiment, an interlayer insulator layer 9 and an upper electrode layer 11 are then formed to complete the non-linear resistance element. The non-linear resistance element thus completed has an elevated threshold voltage level in the same way with the first embodiment, and the value of the threshold voltage can be controlled by adjusting the nitrogen content and thickness of the composite layer 7.

In the second embodiment, the composite layer 7 is interposed between the N-type semiconductor layer 8. However, this composite layer 7 may be inserted in the P-type semiconductor layer 5. Further, although it has been described that the composite layer 7 is located at an intermediate position of an associated semiconductor layer, its location is in no way limited to such a position. For example, the composite layer 7 may be located at the junction between the P-type semiconductor layer 5 and the I-type semiconductor layer 6 or at the junction between the I-type semiconductor layer 6 and the adjacent N-type semicondcutor layer 8. Further, the composite layer 7 may be disposed at end portions of the semicondcutor layers, for example, in the case of the PIN semiconductor, between the P-type semiconductor layer 5 and the transparent electrode layer 2, or at the junction between the upper N-type semiconductor layer 8 and the upper electrode layer 11. Further, though the composite layer 7 is illustrated to have a form of a single layer, two or more composite layers 7 may be used if required.

Embodiment 3

Fig. 4 is a schematic sectional view showing the structure of a third embodiment of the non-linear resistance element according to the present invention. In Fig. 4, like reference numerals are used to designate like parts appearing in Fig. 1.

Referring to Fig. 4, a transparent electrode layer 2 and a buffer layer 3 are laminated in the above-mentioned order on a glass substrate 1 to form a lower electrode layer 4. An N-type semiconductor layer 8a of N-type a-Si:H having a thickness of 100 nm is formed on this lower electrode layer 4, and two I-type semiconductor layers 6 having a composite layer 7 inserted therein are then formed on the N-type semiconductor layer 8a. As in the case of the first embodiment, the I-type semiconductor layers 6 are formed of non-doped I-type a-Si:H produced by the plasma CVD method using silane ($SiH_4$) as a sole raw material gas, and the composite layer 7 is formed of $SiO_x$ ($x > 0$) produced also by the plasma CVD method using a raw material gas in which oxygen (O) is added to silane ($SiH_4$). The composite layer 7 is located at an intermediate portion of the I-type semiconductor layers 6. The total thickness of the I-type semiconductor layers 6 is 200 nm, and the thickness of the composite layer 7 is 20 nm. An N-type semiconductor layer 8b of N-type a-Si:H having a thickness of 100 nm is then formed on the upper I-type semiconductor layer 6, thereby constituting an NIN-type semiconductor layer including the composite layer 7 inserted at an intermediate portion thereof. An interlayer insulator layer 9 of $SiO_2$ having a thickness of 200 nm and having a contact hole 10 is then formed on the NIN-type semiconductor layer, and an upper electrode layer 11 of Cr having a thickness of 100 nm is then formed on the interlayer insulator layer 9.

The NIN element having the above-described structure and including the composite layer inserted therein has in itself a V-I characteristic symmetrical with respect to voltages of positive and negative polarities.

In the case of the first embodiment of the non-linear resistance element, it is necessary that the two elements having the same structure be disposed adjacent to each other and electrically connected with each other to have the form of a ring so as to provide an RD element exhibiting such a V-I characteristic. However, with the NIN element according to the third embodiment, it is possible to eliminate such a necessity and thus to simplify the structure of the RD element.

Fig. 5 shows the voltage-current (V-I) characteristic of the non-linear resistance element shown in Fig. 4. This V-I characteristic was observed when the thickness of the composite layer 7 was set at 20 nm, and the content of oxygen in the raw material gas supplied to form the composite layer 7 was changed, thereby changing the value of x in $SiO_x$. It will be seen that the threshold voltage level can be elevated with an increase in the value of x as in the case of the first embodiment. Further, the threshold voltage level can be controlled in the same way by adjusting the thickness of the composite layer 7.

In the aforementioned embodiments, the composite layer is formed by the plasma CVD (chemical vapor deposition) method. However, the composite layer may be formed by the sputtering method or the ion implantation method. In the case of the ion implantation method, accelerated oxygen ions are implanted in a semiconductor layer of Si, so that the oxygen concentration can be made higher than the oxygen concentration corresponding to the chemical equivalent for $SiO_2$, that is, the stoichiometric oxygen concentration, and the content of the component contained in the semiconductor layer can be controlled over a wide range.

Further, although the plasma CVD method is used to form the other semiconductor layers in the aforementioned embodiments, the present invention is in no way limited to the use of such a specific method, and any suitable one of the sputtering, vacuum deposition, ion plating and other methods may be used to form those semiconductor layers.

Further, although amorphous silicon is used as the material of the semiconductor layers in the aforementioned embodiments, it is apparent that the use of polycrystalline silicon can also attain the same effect.

In each of the aforementioned embodiments, application of the non-linear resistance element to a liquid crystal display device is described by way of example, and, therefore, the transparent electrode layer is formed as a part of the lower electrode layer. However, the above description in no way limits the materials of the upper and lower electrode layers in the present invention.

It will be understood from the foregoing detailed description that the present invention provides a non-linear resistance element which includes a composite layer containing a component having such a property that it provides a chemical equivalent for forming an electrical insulator with a component of a semiconductor layer and wherein the composite layer is inserted in the semiconductor layer formed between two electrode layers. Therefore, the non-linear resistance element is advantageous over prior art elements in that the threshold voltage of the element can be elevated to an appropriate higher level in spite of its simple structure. Therefore, the non-linear resistance element according to the present invention has a remarkable industrial advantage in that, when it is applied, for example, to a liquid crystal display device, it can solve all the problems posed by the above-mentioned prior art elements.

## Claims

1. A non-linear resistance element comprising a semiconductor layer (5, 6, 8; 8a, 6, 8b) formed between two electrode layers (4, 11), and a composite layer (7) inserted in said semiconductor layer, said composite layer containing at least one component capable of providing a chemical equivalent for forming an electrical insulator with a component of said semiconductor layer.

2. A non-linear resistance element according to Claim 1, wherein said semiconductor layer includes a main component of silicon (Si) and is composed of PIN type layers formed by sequentially laminating a P-type semiconductor layer (5), an I-type semiconductor layer (6) and an N-type semiconductor layer (8) in the aforesaid order.

3. A non-linear resistance element according to Claim 1, wherein said semiconductor layer includes a main component of silicon (Si) and is composed of NIN type layers formed by sequentially laminating an N-type semiconductor layer (8a), an I-type semiconductor layer (6) and an N-type semiconductor layer (8b) in the aforesaid order.

4. A non-linear resistance element according to any one of Claims 1, 2 and 3, wherein said composite layer (7) includes a main component formed of at least one of composite components selected from the group consisting of $SiO_x$ ($x > 0$) in which oxygen (O) is contained in Si, $SiN_y$ ($y > 0$) in which nitrogen (N) is contained in Si, and $SiC_z$ ($z > 0$) in which carbon (C) is contained in Si.

# F I G. 1

# F I G. 3

# F I G. 2

F I G. 4

F I G. 6A  PRIOR ART

F I G. 6B  PRIOR ART

# F I G. 5

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | 18th International Conference on Solid State Devices and Materials 1986, Tokyo,Japan pages 675 - 678; Miyazaki et al.: "Resonant Tunneling Through Amorphous Silicon/Silicon Nitride Dubble Barrier Structures." * figure 1 * | 1,3,4 | H 01 L 29/90 |
| A | PATENT ABSTRACTS OF JAPAN vol. 10, no. 268 (E-436)(2324) 12 September 1986, & JP-A-61 91969 (NEC CORP) 10 May 1986, * the whole document * | 1,2 | |
| A | US-A-4 744 862 (SEMICONDUCTOR ENERGY LABORATORY CO) * abstract; figure 4 * | 1 | |
| | | | **TECHNICAL FIELDS SEARCHED (Int. Cl.5)** |
| | | | H 01 L |

The present search report has been drawn up for all claims

| Place of search | Date of completion of search | Examiner |
|---|---|---|
| The Hague | 30 November 90 | NILES N.P.E. |

CATEGORY OF CITED DOCUMENTS

X : particularly relevant if taken alone
Y : particularly relevant if combined with another document of the same catagory
A : technological background
O : non-written disclosure
P : intermediate document
T : theory or principle underlying the invention

E : earlier patent document, but published on, or after the filing date
D : document cited in the application
L : document cited for other reasons

&: member of the same patent family, corresponding document